# DEMANDE DE BREVET EUROPEEN

(11) **EP 2 287 850 A1**
(43) Date de publication de la demande: **23.02.2011**
(21) Numéro de dépôt: 10006824.6
(22) Date de dépôt: 01.07.2010
(51) Int. Cl.: G11C 16/28, G11C 7/06

(54) **Amplificateur de lecture faible puissance auto-minuté**

(30) Priorité: 31.07.2009 FR 0903804
(71) Demandeur: STMicroelectronics (Rousset) SAS, 13790 Rousset (FR)
(72) Inventeur: La Rosa, Francesco, 13790 Rousset (FR)
(74) Mandataire: Marchand, André

(57) **Abrégé**

L'invention concerne un amplificateur de lecture (SA2) comprenant des première (SI1) et seconde (SI2) entrées de détection, un circuit de verrouillage (LT2), un premier transistor de contrôle (CT1) agencé pour alimenter électriquement une première section (IG1) du circuit de verrouillage et présentant une borne de grille (G) reliée à la première entrée de détection (SI1), et un second transistor de contrôle (CT2) agencé pour alimenter électriquement une seconde section (IG2) du circuit de verrouillage et présentant une borne de grille (G) reliée à la seconde entrée de détection (SI2), et moyens (CLP) pour porter la première et la seconde entrées à une tension suffisamment basse pour mettre le premier et le second transistors de contrôle dans l'état passant, lorsqu'au moins l'un des premier et second signaux de données atteint une tension de seuil.

## Description

La présente invention concerne les mémoires non volatiles et plus particulièrement un amplificateur de lecture pour lire des cellules mémoire non volatiles.

Les amplificateurs de lecture sont conventionnellement utilisés pour détecter un état de conductivité de cellules mémoires non volatiles, qui peut généralement être un état de conductivité haute ou un état de conductivité basse, et fournir un signal de données qui dépend de l'état de la cellule mémoire. Par exemple, les cellules de mémoires effaçables et programmables électriquement peuvent être dans un état programmé ou dans un état effacé qui correspondent à deux conductivités différentes.

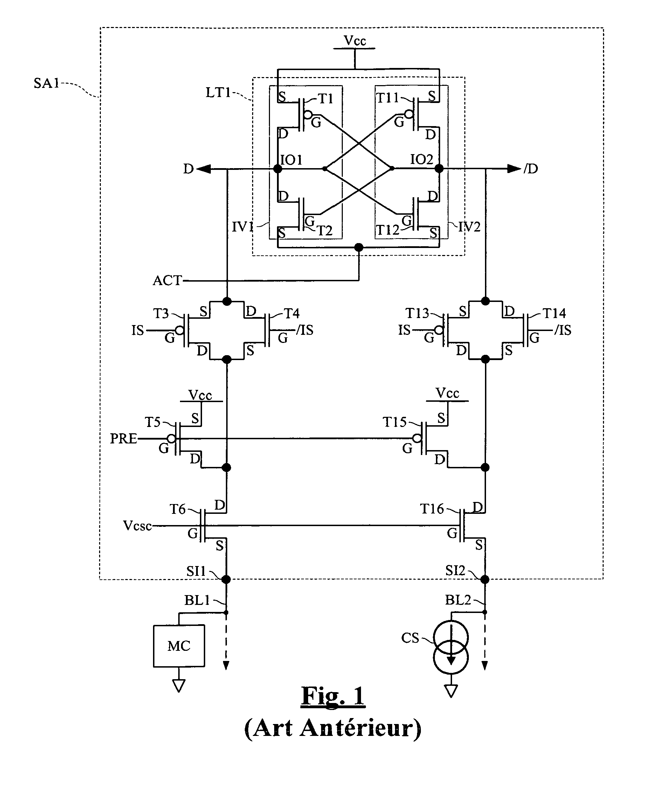

Les amplificateurs de lecture peuvent être asymétriques ou différentiels. Les amplificateurs de lecture asymétriques présentent une source de courant interne ou une source de tension pour détecter, via une seule entrée de détection, l'état d'une cellule mémoire. Les amplificateurs de lecture différentiels présentent deux entrées de détection. La figure 1 illustre un exemple d'amplificateur de lecture différentiel conventionnel SA1, du type décrit dans le brevet américain 5,764,572. L'amplificateur de lecture SA1 présente une première entrée de détection SI1 et une seconde entrée de détection SI2. La première entrée de détection SI1 est reliée à une cellule mémoire MC par l'intermédiaire d'une ligne de bit BL1. La seconde entrée de détection SI2 est connectée à une ligne de référence BL2 reliée à une source de courant CS ou à tout autre élément de référence tel qu'une résistance de référence.

L'amplificateur de lecture SA1 comprend un circuit de verrouillage LT1 comprenant deux portes inverseuses montées tête-bêche IV1, IV2, chacune comprenant un transistor T1, T11 à canal P et un transistor T2, T12 à canal N, respectivement. La sortie de la grille IV1 et l'entrée de la grille IV2 sont connectées à un premier noeud d'entrée/sortie IO1, et la sortie de la grille IV2 et l'entrée de la grille IV1 sont connectées à un second noeud d'entrée/sortie IO2. Le noeud IO1 fournit le signal de données D et le noeud IO2 fournit le signal de données inversé /D.

Le noeud IO1 est également relié à la première entrée de détection SI1 par l'intermédiaire de transistors d'isolation T3, T4 à canal P et à canal N agencés en parallèle, et d'un transistor cascode T6 à canal N. Le noeud IO2 est également relié à la seconde entrée de détection SI2 par l'intermédiaire de transistors d'isolation T13, T14 à canal P et à canal N agencés en parallèle, et d'un transistor cascode T16 à canal N. Les transistors d'isolation T3, T13 sont contrôlés par un signal IS, et les transistors d'isolation T4, T14 sont contrôlés par un signal inversé /IS. Les transistors cascode T6, T16 sont contrôlés par une tension Vcsc.

L'amplificateur de lecture SA1 comprend également des transistors de précharge T5, T15 à canal P contrôlés par un signal de précharge PRE, dont les bornes de drain (D) sont respectivement connectées à la borne de drain (D) du transistor T6 et la borne de drain (D) du transistor T16.

La lecture de la cellule mémoire MC comprend une phase de précharge et une phase de lecture. Lors de la phase de précharge, la première et la seconde entrées de détection sont portées à une tension de précharge Vpre au moyen des transistors T5, T15 et par l'intermédiaire des transistors cascode T6, T16. Une tension Vcc est appliquée sur les bornes de source (S) des transistors T1, T11 du circuit de verrouillage LT1 alors qu'un signal ACT est appliqué sur les bornes de source (S) des transistors T2, T12. Lors de la phase de précharge, le signal ACT est porté à la tension Vcc, maintenant ainsi les transistors T2, T12 dans l'état désactivé.

Une fois que la tension Vpre a été atteinte sur la ligne de bit BL1 et sur la ligne de référence BL2, le signal de précharge PRE est tiré vers le haut et la lecture de la cellule mémoire MC commence. Les tensions présentes sur les première et seconde entrées de détection SI1, SI2 commencent à diminuer à différentes vitesses, créant une différence de tension qui dépend du fait que la cellule mémoire est dans l'état de conductivité haute ou bas. Si la cellule mémoire est dans l'état de conductivité haute, la tension présente sur la ligne de bit BL1 chute plus rapidement que celle sur la ligne de référence BL2. Si la cellule mémoire est dans l'état de conductivité basse, la tension présente sur la ligne de bit BL1 chute plus lentement que celle sur la ligne de référence BL2. La différence de tension entre la ligne de bit et la ligne de référence est amplifiée par les transistors cascode T6, T16 et une différence de tension amplifiée apparaît entre les noeuds IO1, IO2 du circuit de verrouillage.

Les transistors T3, T4, T13, T14 sont ensuite désactivés, déconnectant ainsi les noeuds IO1, IO2 des entrées de détection SI1, SI2, et le verrou est complètement activé en mettant le signal ACT à zéro. La différence de tension amplifiée entre les noeuds IO1, IO2 force le verrou dans un de ses deux états stables possibles, et l'amplificateur de lecture SA1 fournit un signal de données D=0 ou D=1 correspondant à l'état de conductivité de la cellule mémoire.

Un tel amplificateur de lecture conventionnel peut présenter certains inconvénients selon les conditions dans lesquelles il est utilisé ou mis en oeuvre. En particulier, les transistors d'isolation T4, T14 à canal N doivent être assez gros et, dans des circuits intégrés basse tension, doivent être pilotés par une tension survoltée /IS fournie par une pompe de charge puisqu'ils sont agencés dans le chemin de précharge. Par conséquent, une quantité significative d'énergie peut être consommée lorsqu'ils sont commutés par une pompe de charge, pour des questions de rendement des pompes de charge.

De plus, lorsqu'un tel amplificateur de lecture SA1 est mis en oeuvre dans des circuits intégrés basse tension, il peut arriver que le circuit de verrouillage LT1 reste dans un état "métastable" (c'est-à-dire ni à 1 ni à 0), fournissant ainsi un signal de données corrompu. En particulier, un tel problème peut survenir dans des circuits intégrés alimentés par une tension Vcc inférieure à 1,8 V, par exemple ceux fabriqués selon la technologie CMOS 180 nanomètres.

Par conséquent, il peut être souhaité de prévoir un amplificateur de lecture optimisé pour des puces à mémoire basse tension.

Le document US 4 973 864 décrit en relation avec sa figure 7 un amplificateur de lecture comprenant une première entrée de détection, une seconde entrée de détection, un circuit de verrouillage comprenant une première section fournissant un premier signal de données et une seconde section couplée à la première section et fournissant un second signal de données, un premier transistor de contrôle à canal P agencé pour alimenter électriquement la première section et présentant une borne de grille reliée à la première entrée de détection, et un second transistor de contrôle à canal P agencé pour alimenter électriquement la seconde section et présentant une borne de grille reliée à la seconde entrée de détection.

Un tel amplificateur présente un temps de commutation assez long, correspondant au temps de commutation de chaque section.

Des modes de réalisation de l'invention concernent un amplificateur de lecture comprenant une première entrée de détection, une seconde entrée de détection, un circuit de verrouillage comprenant une première section fournissant un premier signal de données et une seconde section couplée à la première section et fournissant un second signal de données, un premier transistor de contrôle à canal P agencé pour alimenter électriquement la première section et présentant une borne de grille reliée à la première entrée de détection, un second transistor de contrôle à canal P agencé pour alimenter électriquement la seconde section et présentant une borne de grille reliée à la seconde entrée de détection, et des moyens de verrouillage agencés pour amener la première et la seconde entrées de détection à une tension suffisamment basse pour mettre le premier et le second transistors de contrôle dans l'état passant, et des moyens pour activer les moyens de verrouillage lorsqu'au moins un des premier et second signaux de données augmente et atteint une tension de seuil.

Selon un mode de réalisation, la première section du verrou comprend au moins une première porte inverseuse, la seconde section du verrou comprend au moins une seconde porte logique inverseuse, et les première et seconde portes inverseuses sont montées tête-bêche.

Selon un mode de réalisation, les moyens pour activer les moyens de verrouillage comprennent une porte OU fournissant un signal de verrouillage lorsqu'une des première et seconde sorties du circuit de verrouillage atteint une tension de seuil de la porte OU.

Selon un mode de réalisation, l'amplificateur de lecture comprend des transistors cascode agencés entre la première entrée de détection et la borne de grille du premier transistor de contrôle et entre la seconde entrée de détection et la borne de grille du second transistor de contrôle.

Selon un mode de réalisation, l'amplificateur de lecture comprend des moyens de précharge pour porter la borne de grille du premier transistor de contrôle et la borne de grille du second transistor de contrôle à une première tension, et pour porter, via les transistors cascode, la première entrée de détection et la seconde entrée de détection à une seconde tension.

Selon un mode de réalisation, une borne de conduction de chacun des premier et second transistors de contrôle reçoit un signal d'activation comme source de tension d'alimentation.

Des modes de réalisation de l'invention concernent également un dispositif à mémoire comprenant des cellules mémoire connectées à des lignes de bit et au moins un amplificateur de lecture selon l'invention, présentant une entrée de détection reliée à au moins une ligne de bit.

Selon un mode de réalisation, le dispositif à mémoire comprend des premier et second plans mémoire, et la première entrée de détection est reliée à des lignes de bit du premier plan mémoire et la seconde entrée de détection est reliée à des lignes de bit du second plan mémoire.

Des modes de réalisation de l'invention concernent également un circuit intégré sur microplaquette de semi-conducteur, comprenant un dispositif à mémoire selon l'invention.

Des modes de réalisation de l'invention concernent également un dispositif portable comprenant un circuit intégré selon l'invention.

Des modes de réalisation de l'invention concernent également un procédé de détection d'une cellule mémoire, comprenant des étapes consistant à fournir un premier signal de données au moyen d'une première section d'un circuit de verrouillage, fournir un second signal de données au moyen d'une seconde section du circuit de verrouillage, couplée à la première section, alimenter électriquement la première section par l'intermédiaire d'un premier transistor de contrôle à canal P, alimenter électriquement la seconde section par un second transistor de contrôle à canal P, relier le premier transistor de contrôle à une ligne de bit à laquelle la cellule mémoire est connectée, relier le second transistor de contrôle à une ligne de référence, et porter la ligne de bit et la ligne de référence à une tension suffisamment basse pour mettre le premier et le second transistors de contrôle dans l'état passant, lorsqu'au moins un des premier et second signaux de données augmente et atteint une tension de seuil.

Selon un mode de réalisation, le procédé comprend en outre des étapes consistant à amplifier une différence de tension présente entre la première entrée de détection et la seconde entrée de détection et appliquer une différence de tension amplifiée entre la première et la seconde bornes de grille des transistors de contrôle.

Selon un mode de réalisation, le procédé comprend une étape de précharge comprenant des étapes consistant à porter la borne de grille du premier transistor de contrôle et la borne de grille du second transistor de contrôle à une première tension, et à porter la première entrée de détection et la seconde entrée de détection à une seconde tension.

Des modes de réalisation d'un amplificateur de lecture selon l'invention et des applications d'un tel amplificateur de lecture seront exposés dans la description suivante faite à titre non limitatif en relation avec les figures jointes parmi lesquelles :
- La figure 1 illustre un amplificateur de lecture différentiel conventionnel,
- La figure 2 illustre un amplificateur de lecture différentiel selon un mode de réalisation de l'invention,
- Les figures 3A à 3F sont des chronogrammes de signaux électriques apparaissant dans l'amplificateur de lecture de la figure 2 lors de la lecture d'une cellule mémoire dans un état de conductivité basse,
- Les figures 4A à 4F sont des chronogrammes de signaux électriques apparaissant dans l'amplificateur de lecture de la figure 2 lors de la lecture d'une cellule mémoire dans un état de conductivité haute,
- La figure 5 illustre un dispositif à mémoire comprenant un amplificateur de lecture selon l'invention, et
- La figure 6 illustre un dispositif portable comprenant un dispositif à mémoire comprenant un amplificateur de lecture selon l'invention.

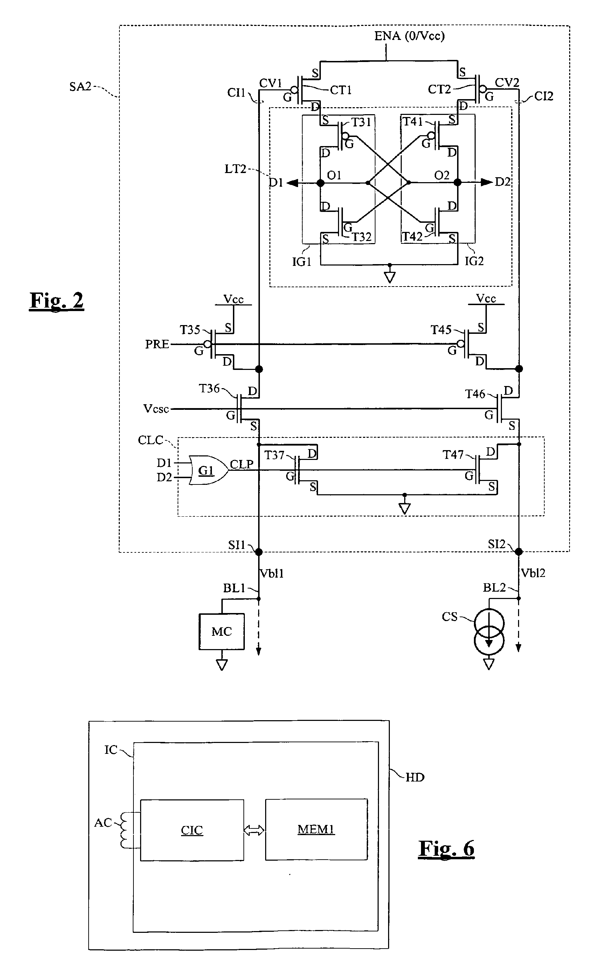

Un amplificateur de lecture SA2 selon un mode de réalisation de l'invention est illustré sur la figure 2. L'amplificateur de lecture SA2 présente une première entrée de détection SI1 et une seconde entrée de détection SI2. La première entrée de détection SI1 est reliée à une cellule mémoire MC par l'intermédiaire d'une ligne de bit BL1. La seconde entrée de détection SI2 est connectée à une ligne de référence BL2 reliée à une source de courant CS ou à tout autre élément de référence tel qu'une résistance de référence. Alternativement, la seconde entrée de détection SI2 peut être reliée à une cellule mémoire MC par l'intermédiaire d'une ligne de bit, et la première entrée de détection SI1 peut être reliée à une ligne de référence reliée à une source de courant ou un autre élément de référence.

L'amplificateur de lecture SA2 comprend un circuit de verrouillage LT2 comprenant une première section IG1, une seconde section IG2 couplée à la première section IG1, un premier noeud de sortie O1 et un second noeud de sortie O2. La première section IG1 présente une sortie connectée au noeud de sortie O1 et fournit un signal de données logique D1. La seconde section IG2 présente une sortie connectée au noeud de sortie O2 et fournit un signal de données logique D2. Chaque section IG1, IG2 est alimentée par un signal d'activation ENA qui est porté à une tension Vcc (ENA=1) lorsque le circuit de verrouillage doit être activé et qui est mis à la masse (ENA=0) lorsque le circuit de verrouillage doit être désactivé. Des moyens pour forcer à 0 des signaux de données D1, D2 lorsque le signal d'activation ENA est égal à 0 peuvent également être prévus, par exemple des transistors à canal N connectés entre les sorties O1, O2 (non illustrées) et la masse et contrôlés par un signal /ENA qui est égal à Vcc lorsque ENA est égal à 0, et vice-versa.

Selon l'invention, le signal d'alimentation ENA, c'est-à-dire la tension d'alimentation Vcc lorsque ENA=1, est appliqué à la première section IG1 par l'intermédiaire d'un premier transistor de contrôle CT1 à canal P, et est appliqué à la seconde section IG2 par un second transistor de contrôle CT2 à canal P. La borne de grille (G) du transistor CT1 forme une première entrée de contrôle CI1 du circuit de verrouillage LT2 et est reliée à la première entrée de détection SI1 de l'amplificateur de lecture SA2. La borne de grille (G) du transistor CT2 forme une seconde entrée de contrôle CI2 du circuit de verrouillage et est reliée à la seconde entrée de détection SI2 de l'amplificateur de lecture SA2.

Dans le mode de réalisation illustré sur la figure 2, la première entrée de contrôle CI1 du circuit de verrouillage est reliée à la première entrée de détection SI1 par l'intermédiaire d'un transistor cascode T36 à canal N et la seconde entrée de contrôle CI2 du circuit de verrouillage est reliée à la seconde entrée de détection SI2 par un transistor cascode T46 à canal N. Les transistors cascode T36, T46 sont contrôlés par une tension Vcsc appliquée sur leurs bornes de grille (G).

Toujours dans le mode de réalisation illustré sur la figure 2, les première et seconde sections IG1, IG2 sont des portes inverseuses montées tête-bêche, l'entrée de la porte IG1 étant connectée à la sortie de la porte IG2 et vice-versa. La porte inverseuse IG1 comprend par exemple un transistor T31 à canal P et un transistor T32 à canal N ayant leurs bornes de drain (D) connectées au noeud de sortie O1 et leurs bornes de grille (G) connectées au noeud de sortie O2. La borne de source (S) du transistor T32 est connectée à la masse et la borne de source (S) du transistor T31 est connectée à la borne de drain (D) du transistor de contrôle CT1, dont la borne de source (S) reçoit l'alimentation et le signal d'activation ENA. De même, la porte inverseuse IG2 comprend par exemple un transistor T41 à canal P et un transistor T42 à canal N ayant leurs bornes de drain (D) connectées au noeud de sortie O2 et leurs bornes de grille (G) connectées au noeud de sortie O1. La borne de source (S) du transistor T42 est connectée à la masse et la borne de source (S) du transistor T41 est connectée à la borne de drain (D) du transistor de contrôle CT2, dont la borne de source (S) reçoit l'alimentation et le signal d'activation ENA.

L'amplificateur de lecture SA2 comprend en outre des transistors de précharge T35, T45 à canal P. Chaque transistor de précharge T35, T45 a sa borne de drain (D) connectée à une entrée de contrôle du circuit de verrouillage, respectivement CI1, CI2, reçoit la tension Vcc sur sa borne de source (S), et un signal de précharge PRE sur sa borne de grille (G).

L'amplificateur de lecture SA2 comprend également un circuit de verrouillage CLC. Le circuit de verrouillage CLC comprend deux transistors T37, T47 à canal N. Chaque transistor T37, T47 a sa borne de drain (D) connectée à une entrée de détection SI1, SI2 respectivement, sa borne de source (S) connectée à la masse, et reçoit un signal de verrouillage CLP sur sa borne de grille (G).

Dans un mode de réalisation, le signal de verrouillage CLP est automatiquement activé lorsque l'un des premier et second signaux de données D1, D2 augmente et atteint une tension de seuil. Comme illustré sur la figure 2, le signal de verrouillage CLP est par exemple fourni par une porte OU G1 qui reçoit les premier et second signaux de données D1, D2 en entrée.

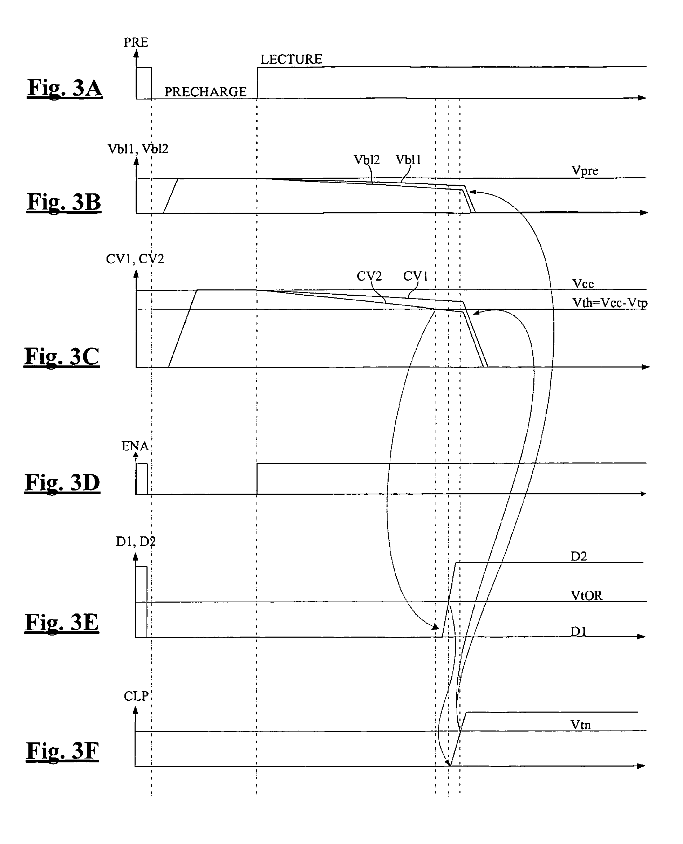

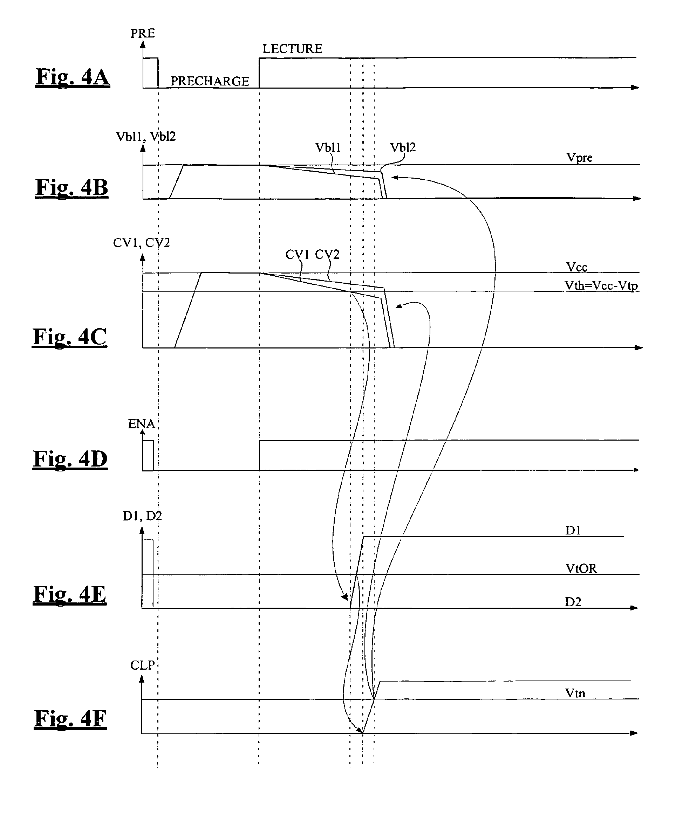

Le fonctionnement de l'amplificateur de lecture SA2 va maintenant être décrit. Les figures 3A à 3F illustrent différents signaux et différentes tensions dans l'amplificateur de lecture SA2 lors des phases de précharge et de lecture, lorsque la cellule mémoire MC est dans un état de conductivité basse (par exemple un état programmé). Les figures 4A à 4F illustrent les mêmes signaux et les mêmes tensions dans l'amplificateur de lecture SA2 lors des mêmes phases de précharge et de lecture, lorsque la cellule mémoire MC est dans un état de conductivité haute (par exemple un état effacé).

Plus particulièrement, les figures 3A, 4A illustrent la forme du signal de précharge PRE, les figures 3B, 4B illustrent les formes des tensions de lignes de bit Vbl1 et Vbl2 qui sont respectivement présentes sur les entrées de détection SI1 et SI2, les figures 3C, 4C illustrent la forme des tensions de contrôle CV1 et CV2 respectivement présentes sur les entrées de contrôle CI1 et CI2, les figures 3D, 4D illustrent la forme du signal d'activation ENA, les figures 3E, 4E illustrent la forme des signaux de données D1 et D2 fournis par les noeuds de sortie O1 et O2, et les figures 3F, 4F illustrent la forme du signal de verrouillage CLP.

Comme indiqué précédemment, la seconde entrée de détection SI2 est reliée à la source de courant CS par l'intermédiaire de la ligne de référence BL2. Il est supposé que la source de courant CS tire un courant constant dont la valeur est réglée entre le courant passant dans une cellule mémoire dans l'état de conductivité haute et celui passant dans une cellule mémoire dans l'état de conductivité basse.

La phase de précharge débute lorsque le signal PRE est réglé sur zéro (figures 3A, 4A) de telle sorte que les transistors T35, T45 à canal P deviennent passants. La tension cascode Vcsc est appliquée à la grille des transistors T36, T46. Il en résulte que les tensions de lignes de bit Vbl1 et Vbl2 commencent à augmenter (figures 3B, 4B) jusqu'à ce qu'elles atteignent une tension de précharge Vpre approximativement égale à Vcsc-Vgs, Vgs étant la tension grille-source des transistors T36, T46. Les tensions de contrôle CV1, CV2 sur les entrées de contrôle CI1, CI2 augmentent également et atteignent une tension égale à Vcc (figures 3C, 4C).

Il est supposé que le signal d'activation ENA a précédemment été mis à zéro (figures 3D, 4D) de telle sorte que le circuit de verrouillage LT2 est désactivé et que ses noeuds de sortie O1, O2 sont dans l'état HZ (haute impédance). Par conséquent, dans les figures 3E, 4E, les signaux de données D1, D2 sont illustrés comme étant égaux à zéro lors de la phase de précharge.

L'amplificateur de lecture SA2 entre en phase de lecture lorsque le signal de précharge PRE repasse à 1 (figure 3A) pour désactiver les transistors T35, T45. Approximativement au même moment, le signal d'activation ENA est mis à 1 (Vcc). Comme elles ne sont plus en train d'être chargées, la ligne de bit BL1 et la ligne de référence BL2 commencent à se décharger (figures 3B, 4B). Les tensions de lignes de bit Vbl1, Vbl2 commencent à diminuer à partir de Vcsc-Vgs (figures 3B, 4B) et les tensions de contrôle CV1, CV2 commencent à diminuer à partir de Vcc (figures 3C, 4C).

Si la cellule mémoire MC est en état de conductivité basse, le courant passant dans la cellule mémoire est inférieur au courant de référence tiré par la source de courant. Par conséquent, la ligne de référence BL2 se décharge plus rapidement que la ligne de bit BL1 et, comme illustré sur la figure 3B, la tension Vbl2 diminue plus rapidement que la tension Vbl1. La différence de tension entre Vbl1, Vbl2 est amplifiée par les transistors cascode T36, T46 et une différence de tension plus importante apparaît entre les tensions de contrôle CV1, CV2. La tension CV2 diminue plus rapidement que la tension CV1, comme illustré sur la figure 3C.

Si la cellule mémoire MC est en état de conductivité haute, le courant passant par la cellule mémoire est supérieur au courant de référence tiré par la source de courant. Par conséquent, la ligne de bit BL1 se décharge plus rapidement que la ligne de référence BL2 et, comme illustré sur la figure 4B, la tension Vbl1 diminue plus rapidement que la tension Vbl2. La différence de tension entre Vbl1, Vbl2 est amplifiée par les transistors cascode T36, T46 et la tension CV1 diminue plus rapidement que la tension CV2, comme illustré sur la figure 4C.

Dans les deux cas, la tension CV1 ou CV2 qui diminue le plus rapidement atteint une tension de seuil Vth telle que le transistor correspondant CT1 ou CT2 devient passant. Les transistors CT1 et CT2 étant du type P et le circuit de verrouillage étant alimenté par la tension Vcc (fournie en tant que signal d'activation ENA), une telle tension de seuil Vth est ici égale à Vcc-Vtp, Vtp étant la tension de seuil des transistors CT1, CT2 à canal P.

Sur la figure 3C, la tension CV2 est la première à atteindre la tension de seuil Vth, de telle sorte que le transistor de contrôle CT2 est le premier à devenir passant. Par conséquent, le transistor CT2 passe la tension Vcc à la porte inverseuse IG2, et le signal de données D2 au noeud de sortie O2 commence à augmenter comme illustré sur la figure 3E.

Sur la figure 4C, la tension de contrôle CV1 est la première à atteindre la tension de seuil Vth, de telle sorte que le transistor de contrôle CT1 est le premier à devenir passant. Par conséquent, le transistor CT1 passe la tension Vcc à la porte inverseuse IG1, et le signal de données D1 au noeud de sortie O1 commence à augmenter comme illustré sur la figure 4E.

Puis, le signal D2 ou le signal D1 atteint une valeur de seuil VtOR de la porte OU G1 et le signal de verrouillage CLP passe de 0 à 1 (Vcc) (figure 3F ou 4F). Lorsque le signal de verrouillage atteint une tension de seuil Vtn des transistors T37, T47 à canal N, le dernier devient passant et connecte la première et la seconde entrées de détection SI1, SI2 à la masse. Les tensions de lignes de bit Vbl1, Vbl2, ainsi que les tensions de contrôle CV1, CV2 sont tirées vers la masse (figures 3B et 3C, 4B et 4C) qui met les deux transistors de contrôle CT1, CT2 à canal P dans l'état complètement passant. Le circuit de verrouillage devient complètement opérationnel et verrouille les valeurs provisoires des signaux de données D1 et D2, c'est-à-dire D1=0 et D2=1 sur la figure 3E ou D1=1 et D2=0 sur la figure 4E, qui deviennent les valeurs de données verrouillées finales pour la phase de lecture actuelle.

Il sera noté que grâce à l'utilisation de la borne de grille des transistors de contrôle CT1, CT2 comme "moyens de détection" en combinaison avec l'alimentation du circuit de verrouillage par de tels transistors, les transistors d'isolation décrits ci-dessus en relation avec la figure 1 ne sont plus nécessaires. Ces transistors sont nécessaires dans l'art antérieur pour déconnecter les entrées du verrou à partir des entrées de détection lors de la phase de lecture, et échantillonner la différence de tension entre l'entrée de détection sans que les noeuds de sortie du circuit de verrouillage interagissent avec la ligne de bit détectée.

D'autre part, l'utilisation des valeurs provisoires des signaux de données D1, D2 pour activer le circuit de verrouillage CLP, qui en retour fait devenir le circuit de verrouillage complètement opérationnel et verrouille les valeurs provisoires D1, D2, rend l'amplificateur de lecture SA2 "auto-minuté".

De plus, il sera noté que des modes de réalisation d'un amplificateur de lecture selon l'invention peuvent comprendre différents autres types de moyens de précharge, des moyens cascode (c'est-à-dire des moyens de limitation de tension) et des moyens de verrouillage différents de ceux qui ont été décrits ci-dessus. De plus, les première et seconde sections IG1, IG2 du verrou sont susceptibles de divers autres modes de réalisation et peuvent comprendre, par exemple, d'autres portes logiques telles que des portes NON-ET, des portes NON-OU, des transistors en série ou en parallèle, etc., en fonction de ce que souhaite l'homme de l'art désirant mettre en oeuvre l'invention conformément à la présente description.

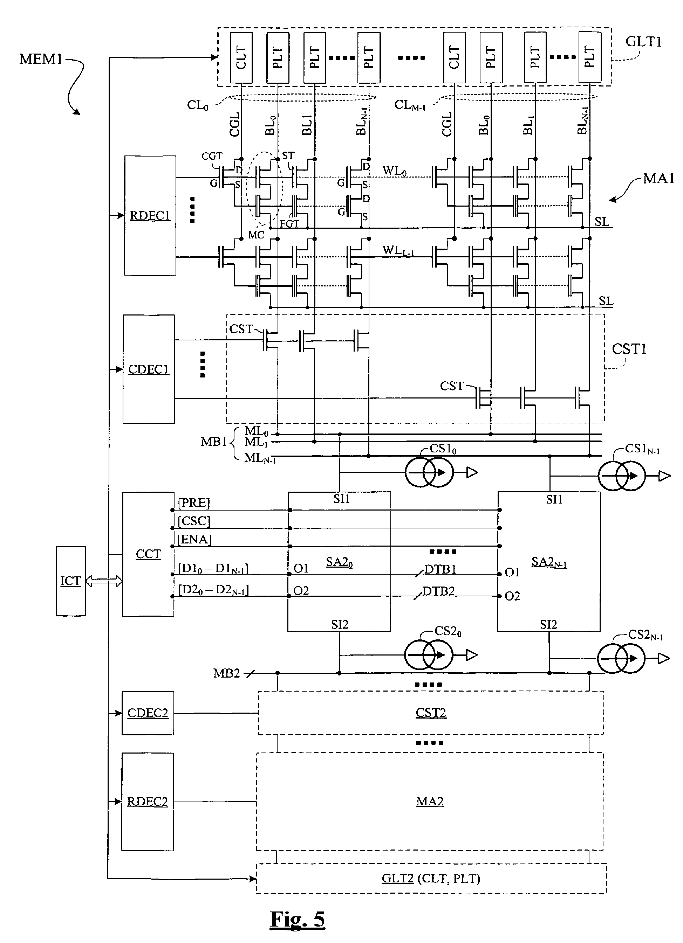

La figure 5 illustre un exemple d'application dans lequel une série d'amplificateurs de lecture selon l'invention est incorporée dans un dispositif à mémoire non volatile effaçable et programmable électriquement MEM1. Le dispositif à mémoire MEM1 comprend deux plans mémoire MA1, MA2. Le plan mémoire MA2 présente la même structure que le plan mémoire MA1 et est illustré sous forme d'un bloc. Chaque plan mémoire MA1, MA2 comprend L lignes de mot WL (WL₀-WL_{L-1}) et M colonnes CL (CL₀ à CL_{M-1}). Chaque colonne CL comprend N lignes de bit BL (BL₀-BL_{N-1}) et une ligne de grille de contrôle CGL. Chaque plan mémoire MA1, MA2 comprend L*M*N cellules mémoires MC. Dans cet exemple, les plans mémoire MA1, MA2 sont effaçables par mot et programmables par mot, un mot comprenant des cellules mémoire de la même colonne connectées à la même ligne de mot.

Chaque cellule mémoire MC dans un mot comprend un transistor de sélection ST et un transistor à grille flottante FGT. Le transistor de sélection ST a sa borne de drain (D) connectée à une ligne de bit BL, sa borne de source (S) connectée à la borne de drain (D) du transistor à grille flottante, et sa borne de grille (G) connectée à une ligne de mot WL. Le transistor à grille flottante FGT a sa borne de source (S) connectée à une ligne de source SL et sa borne de grille (G) connectée à la borne de source (S) d'un transistor à grille de contrôle CGT. Le transistor à grille de contrôle CGT a sa borne de grille (G) connectée à la ligne de mot considérée et sa borne de drain (D) connectée à la ligne de grille de contrôle CGL de la colonne considérée.

Le dispositif à mémoire MEM1 comprend en outre un premier et un second décodeurs de rangée RDEC1, RDEC2, un premier et un second décodeurs de colonne CDEC1, CDEC2, un premier et un second groupes GLT1, GLT2 de verrous de colonne CLT et de verrous de programmation PLT, un premier et un second groupes CST1, CST2 de transistors de sélection de colonne CST, un premier et un second bus de multiplexage MB1, MB2, une rangée centrale de N a-mplificateurs de lecture SA2 (SA2₀-SA2_{N-1}) selon l'invention, et un circuit de contrôle central CCT tel qu'un microprocesseur, un séquenceur microprogrammé, ou une machine d'état recevant des commandes et des données de l'extérieur et fournissant des réponses et des données à l'extérieur par l'intermédiaire d'un circuit d'interface de communication ICT.

Le décodeur de rangée RDEC1 fournit des signaux de sélection de rangée aux lignes de mots WL (WL₀-WL_{L-1}) du plan mémoire MA1 et le décodeur de rangée RDEC2 fournit des signaux de sélection de rangée aux lignes de mots du plan mémoire MA2. Le décodeur de colonne CDEC1 fournit des signaux de sélection de colonne aux transistors de sélection de colonne CST du groupe CST1 et le décodeur de colonne CDEC2 fournit des signaux de sélection de colonne aux transistors de sélection de colonne du groupe CST2.

Les lignes de bit du plan mémoire MA1 appartenant à différentes colonnes et présentant le même rang ou le même poids (c'est-à-dire stockant des bits de même rang des différents mots) sont reliées à l'entrée de détection SI1 du même amplificateur de lecture SA2 par l'intermédiaire des transistors de sélection de colonne CST du groupe CST1 et le bus de multiplexage MB1. De la même façon, les lignes de bit du plan mémoire MA2 appartenant à différentes colonnes et présentant le même rang ou le même poids sont reliées à l'entrée de détection SI2 du même amplificateur de lecture SA2 par l'intermédiaire des transistors de sélection de colonne du groupe CST2 et le bus de multiplexage MB2. Par exemple, les lignes de bit BL₀ des colonnes CL₀ à CL_{M-1}, sont reliées à l'amplificateur de lecture SA2₀ par l'intermédiaire de transistors CST et une ligne ML₀ du bus de multiplexage MB1. Les lignes de bit BL_{N-1} des colonnes CL₀ à CL_{M-1} sont reliées à l'amplificateur de lecture SA2_{N}-₁ par l'intermédiaire de transistors CST et une ligne ML_{N-1} du bus de multiplexage MB1.

Le circuit de contrôle CCT fournit le signal de précharge PRE, le signal cascode CSC, et le signal d'activation ENA décrits ci-dessus aux amplificateurs de lecture SA2₀-SA2_{N-1}. Les sorties O1 des amplificateurs de lecture SA2₀-SA2_{N-1} sont connectées à différentes lignes d'un bus de données DTB1 et les sorties O2 sont connectées à différentes lignes d'un bus de données DTB2.

Enfin, chaque entrée de détection SI1 de chaque amplificateur de lecture SA2₀ à SA2_{N-1} est reliée à une source de courant CS1₀ à CS1_{N-1} par l'intermédiaire d'une ligne de référence et chaque entrée de détection SI2 de chaque amplificateur de lecture SA2₀ à SA2_{N-1} est reliée à une source de courant CS2₀ à CS2_{N-1} par l'intermédiaire d'une ligne de référence. Chaque source de courant CS1, CS2 est agencée entre l'entrée de détection et les lignes de multiplexage, comme illustré sur la figure 5, mais peut également être connectée à une ligne de bit à laquelle l'entrée de détection considérée est reliée par le bus de multiplexage.

Les étapes de programmation et d'effacement de cellules mémoire ne seront pas décrites en détails et sont effectuées par le circuit de contrôle CCT, qui contrôle les décodeurs RDEC1, RDEC2, CDEC1, CDEC2 et leur fournit des adresses de rangée et de colonne reçues par l'intermédiaire de l'interface ICT, ainsi que des signaux de contrôle et une tension de programmation ou d'effacement Vpp. Le circuit de contrôle CCT fournit également aux verrous de programmation des données reçues par l'intermédiaire de l'interface ICT, et les verrous de colonne sont sélectionnés et activés par les signaux de sélection de colonne fournis par le décodeur de colonne CDEC1. L'effacement d'un mot comprend des étapes consistant à appliquer la tension Vpp sur la ligne de mot correspondant, par l'intermédiaire d'un décodeur de rangée RDEC1 ou RDEC2, et appliquer la tension Vpp sur la ligne de grille de contrôle correspondante CGL par le verrou de colonne correspondant CLT alors que la ligne de source correspondante est connectée à la masse. La programmation des cellules mémoire comprend des étapes consistant à appliquer la tension Vpp aux lignes de bit correspondantes par l'intermédiaire des verrous de programmation correspondants, appliquer la tension Vpp à la ligne de mot correspondante, et connecter à la masse la ligne de grille de contrôle correspondante CGL par le verrou de colonne correspondant.

Une étape consistant à lire des cellules mémoire est effectuée par le circuit de contrôle CCT au moyen des amplificateurs de lecture SA2, et comprend l'activation des sources de courant du plan mémoire opposé au plan mémoire dans lequel les cellules mémoire à lire sont situées, puis le préchargement des lignes de bit et la lecture du signal de données D1 ou D2 sur le bus de données correspondant DTB1 ou DTB2. Par exemple, si des cellules mémoire dans le plan mémoire MA1 doivent être lues, le circuit de contrôle CCT sélectionne d'abord la ligne de mot correspondante au moyen du décodeur de rangée RDEC1, et connecte les N lignes de bit de la colonne concernée aux amplificateurs de lecture SA2₀ à SA2_{N-1} au moyen du décodeur de colonne CDEC1 et par les transistors de sélection de colonne CST du groupe CST1. Le circuit CCT active ensuite les sources de courant CS2 dans le plan mémoire MA2, applique les signaux de précharge, cascode et d'activation PRE, CSC, ENA de la façon décrite ci-dessus aux amplificateurs de lecture SA2, lit les données D1 sur le bus de données DTB1 (chaque amplificateur de lecture fournit un bit d'un mot D1₀ à D1_{N-1}), puis les fournit à l'extérieur par l'intermédiaire de l'interface ICT.

Il sera noté que cet exemple de réalisation d'un dispositif à mémoire utilisant des amplificateurs de lecture selon l'invention a été décrit comme un exemple non limitatif. Des modes de réalisation d'amplificateurs de lecture selon l'invention peuvent être mis en oeuvre dans divers types d'architectures de mémoire, et peuvent être utilisés dans toute application dans laquelle l'état d'une cellule mémoire peut être déterminé en détectant une chute de tension sur les bornes de la cellule mémoire. Des amplificateurs de lecture SA2 peuvent également être utilisés dans des dispositifs à mémoire ne présentant pas un plan mémoire dual tel que décrit ci-dessus. Dans ce cas, la seconde entrée de détection SI2 est connectée à une ligne de référence qui n'est pas reliée à des lignes de bit du plan mémoire.

Un dispositif à mémoire comprenant des amplificateurs de lecture selon l'invention est également susceptible de nombreux modes de réalisation et de nombreuses applications. Par exemple, la figure 6 illustre schématiquement un dispositif portable HD comprenant un circuit intégré IC dans lequel la mémoire MEM1 décrite ci-dessus ou tout autre type de mémoire non volatile comprenant des amplificateurs de lecture selon l'invention est intégrée. Dans un mode de réalisation, le dispositif portable HD peut être une carte à puce sans contact, une étiquette, un téléphone portable, un PDA, etc., et peut comprendre un circuit d'interface de communication sans contact CIC auquel la mémoire MEM1 est connectée. Le circuit d'interface CIC peut être un circuit d'interface NFC (Near Field Communication) connecté à une bobine d'antenne AC, configuré pour échanger des données par couplage inductif et modulation de charge, ou peut être un circuit d'interface UHF connecté à une antenne UHF (non illustrée) et configuré pour échanger des données par couplage électrique et rétrodiffusion. Le dispositif portable HD peut être configuré pour communiquer avec un dispositif externe tel qu'une carte ou un lecteur d'étiquette sans contact, un point de vente, un autre téléphone portable NFC, etc. La mémoire MEM1 peut être utilisée à la fois pour stocker du code (en particulier des programmes d'application) et des données d'applications.

## Revendications

1. Amplificateur de lecture (SA2) comprenant :
- une première entrée de détection (SI1),
- une seconde entrée de détection (SI2), et
- un circuit de verrouillage (LT2) comprenant une première section (IG1) fournissant un premier signal de données (D1) et une seconde section (IG2) couplée à la première section et fournissant un second signal de données (D2),
- un premier transistor de contrôle (CT1) à canal P agencé pour alimenter électriquement (ENA, Vcc) la première section (IG1) et présentant une borne de grille (G) reliée à la première entrée de détection (SI1), et
- un second transistor de contrôle (CT2) à canal P agencé pour alimenter électriquement (ENA, Vcc) la seconde section (IG2) et présentant une borne de grille (G) reliée à la seconde entrée de détection (SI2).
**caractérisé en ce qu'**il comprend en outre :
- des moyens de verrouillage (CLP, T37, T47) agencés pour porter la première et la seconde entrées de détection (SI1, SI2) à une tension suffisamment basse pour mettre le premier et le second transistors de contrôle dans l'état passant, et
- des moyens (G1) pour activer les moyens de verrouillage lorsqu'au moins l'un des premier et second signaux de données (D1, D2) augmente et atteint une tension de seuil.

2. Amplificateur de lecture selon la revendication 1, dans lequel :
- la première section (IG1) du verrou comprend au moins une première porte inverseuse (IG1),
- la seconde section (IG2) du verrou comprend au moins une seconde porte inverseuse (IG2), et
- la première et la seconde portes inverseuses sont montées tête-bêche.

3. Amplificateur de lecture selon l'une des revendications 1 et 2, dans lequel les moyens pour activer les moyens de verrouillage comprennent une porte OU (G1) fournissant un signal de verrouillage (CLP) lorsqu'une des première et seconde sorties du circuit de verrouillage atteint une tension de seuil de la porte OU.

4. Amplificateur de lecture selon l'une des revendications 1 à 3, comprenant des transistors cascode (T36, T46) agencés entre la première entrée de détection (SI1) et la borne de grille du premier transistor de contrôle (CT1) et entre la seconde entrée de détection (SI2) et la borne de grille du second transistor de contrôle (CT2).

5. Amplificateur de lecture selon la revendication 4, comprenant des moyens de précharge (T35) pour porter la borne de grille du premier transistor de contrôle (CT1) et la borne de grille du second transistor de contrôle (CT2) à une première tension (Vcc), et pour porter, via les transistors cascode (T36, T46), la première entrée de détection (SI1) et la seconde entrée de détection (SI2) à une seconde tension (Vpre).

6. Amplificateur de lecture selon l'une des revendications 1 à 5, dans lequel une borne de conduction de chacun des premier et second transistors de contrôle (CT1, CT2) reçoit un signal d'activation (ENA) comme source de tension d'alimentation (Vcc).

7. Dispositif à mémoire (MEM1) comprenant des cellules mémoire connectées à des lignes de bit (BL) et au moins un amplificateur de lecture selon l'une des revendications 1 à 6 présentant une entrée de détection reliée à au moins une ligne de bit (BL).

8. Dispositif à mémoire selon la revendication 7, présentant un premier et un second plans mémoire (MA1, MA2), et dans lequel la première entrée de détection (SI1) est reliée à des lignes de bit (BL₀-BL_{N-1}) du premier plan mémoire et la seconde entrée de détection (SI2) est reliée à des lignes de bit du second plan mémoire.

9. Circuit intégré (IC) sur une microplaquette de semi-conducteur, comprenant un dispositif à mémoire (MEM1) selon l'une des revendications 7 ou 8.

10. Dispositif portable (HD), comprenant un circuit intégré selon la revendication 9.

11. Procédé de détection d'une cellule mémoire (MC), comprenant des étapes consistant à :
- fournir un premier signal de données (D1) au moyen d'une première section (IG1) d'un circuit de verrouillage (LT2),
- fournir un second signal de données (D2) au moyen d'une seconde section (IG2) du circuit de verrouillage, couplée à la première section,
- alimenter électriquement (ENA, Vcc) la première section (IG1) par l'intermédiaire d'un premier transistor de contrôle (CT1) à canal P,
- alimenter électriquement (ENA, Vcc) la seconde section (IG2) par l'intermédiaire d'un second transistor de contrôle (CT2) à canal P,
- relier le premier transistor de contrôle (CT1) à une ligne de bit (BL1) à laquelle la cellule mémoire (MC) est connectée, et
- relier le second transistor de contrôle (CT2) à une ligne de référence (BL2),
**caractérisé en ce qu'**il comprend également une étape consistant à porter la ligne de bit (BL1) et la ligne de référence (BL2) à une tension suffisamment basse pour mettre le premier et le second transistors de contrôle (CT1, CT2) dans l'état passant, lorsqu'au moins un des premier et second signaux de données (D1, D2) augmente et atteint une tension de seuil.

12. Procédé selon la revendication 11, comprenant en outre des étapes consistant à amplifier une différence de tension présente entre la première entrée de détection (SI1) et la seconde entrée de détection (SI2) et appliquer une différence de tension amplifiée entre la première et la seconde bornes de grille des transistors de contrôle (CI1, CI2).

13. Procédé selon l'une des revendications 11 et 12, comprenant une étape de précharge comprenant des étapes consistant à porter la borne de grille du premier transistor de contrôle (CT1) et la borne de grille du second transistor de contrôle (CT2) à une première tension (Vcc), et à porter la première entrée de détection (SI1) et la seconde entrée de détection (SI2) à une seconde tension (Vpre).
